# EUROPEAN PATENT SPECIFICATION

(11) **EP 3 382 897 B1**
(45) Date of publication and mention of the grant of the patent: **01.06.2022**
(21) Application number: 17163227.6
(22) Date of filing: 28.03.2017
(51) Int. Cl.: H03K 17/96

(54) **CONTROL DEVICE, IN PARTICULAR FOR A DOMESTIC APPLIANCE**
STEUERUNGSVORRICHTUNG, INSBESONDERE FÜR EIN HAUSHALTSGERÄT
DISPOSITIF DE COMMANDE, EN PARTICULIER POUR UN APPAREIL DOMESTIQUE

(43) Date of publication of application: 03.10.2018
(73) Proprietor: Electrolux Appliances Aktiebolag, 105 45 Stockholm (SE)
(72) Inventor: BUMANN, Veronika, 91541 Rothenburg ob der Tauber (DE); HAUCK, Alexander, 91541 Rothenburg/Tauber (DE)
(74) Representative: Electrolux Group Patents

(56) References cited:
- EP-A1- 1 542 363
- EP-A1- 2 690 786
- EP-A2- 1 816 747
- WO-A2-2010/043417
- DE-A1-102013 112 651
- US-A1- 2014 332 361

## Description

The present invention relates to a control device according to the preamble of claim 1. In particular, the present invention relates to a control device for a domestic appliance according to the preamble of claim 1.

A control device, in particular for a domestic appliance, includes often touch switches. For example, said touch switches may be of a capacitive type, an inductive type, an optical type or an infrared type. The touch switches do not require any mechanical elements.

US 2009/0090605 A1 discloses a control device for an electrical appliance. The control device includes a front panel and a printed circuit board arranged behind and parallel to said front panel. The printed circuit board includes a cut-out. Said cut-out is covered by a polymeric film acting as light filter. An annular track is attached at the rear side of the printed circuit board and acts as a touch electrode for a touch switch. However, said touch switch is relative complex.

EP 1 542 363 A1 discloses a keypad for vending machines. The keypad comprises a front panel, a printed circuit board and a transparent film. The printed circuit board is arranged behind the front panel. The transparent film is arranged in front of the printed circuit board and covers an opening in said printed circuit board. Conductive zones are arranged on the rear side of the transparent film and on the front side of the printed circuit board. The conductive zones of the transparent film and the printed circuit board are connected by conducting glue.

EP 2 690 786 A1 discloses a control device for a domestic appliance. The control device includes a front panel and a button panel arranged behind said front panel. At least one switch is responsive to touching a switchable area at the front side of the front panel. The electrodes are formed as inner and outer tracks enclosing the cut-outs in the button panel. Said inner and outer tracks are arranged between the front panel and button panel. Light source elements are arranged at the rear side of the button panel. At least one reflector element reflects the light from the source elements to the rear side of the button panel.

EP 1 816 747 A2 discloses a capacitive touch switch. The touch switch includes a sensor element changing its capacity in contact with a person. The sensor element is connected to a measuring electrode having a first potential. The measuring electrode is partially enclosed by an additional electrode in order to shield said measuring electrode. The measuring electrode and the additional electrode are attached at a printed circuit board. The measuring electrode and the additional electrode are arranged at the same side and/or at the opposite side of said printed circuit board.

DE 10 2013 112 651 A1 discloses a multilayer body for providing a multilayer pushbutton functionality. D4 discloses an electrode layer realized as single layer. The document further discloses a support for the multilayer body and or the layer electrode to be a transparent sheet f.e. made from PET or PE or glass.

US 2014/0332361 A1 discloses D5 a touch inductive unit including a receiving electrode pattern and a driving electrode pattern.

It is an object of the present invention to provide a control device, which provides a touch switch by low complexity.

The object of the present invention is achieved by the control device according to claim 1.

According to the present invention a further conductive layer is applied at the front side of the transparent or opal sheet and arranged in front of the cut-out, wherein said further conductive layer forms a further electrode of the touch sensitive switch, and wherein the conductive layers are applied at the sheet according to predefined patterns, and wherein the conductive layers at the rear side and front side of the sheet have different patterns.

The conductive layers applied at the sheet provide the electrodes for the touch sensitive switch by low complexity. The electrodes are arranged in a central position of the touch sensitive switch.

Preferably, the sheet is a transparent or opal foil.

Moreover, at least one electronic and/or electric circuit may be arranged at the rear side of the printed circuit board.

Preferably, the conductive layer is or the conductive layers are, respectively, electrically connected to the electronic and/or electric circuit at the printed circuit board.

In particular, the sheet is aligned at the front side of the printed circuit board.

Further, the rear side of the sheet may be connected to the front side of the printed circuit board by at least one adhesive tape.

For example, the printed circuit board with the sheet is pressed at the rear side of the front panel by mechanical fastening elements.

Alternatively or additionally, the front side of the sheet may be connected to the rear side of the front panel by at least one further adhesive tape.

In particular, at least one light source element is arranged at the rear side of the printed circuit board, wherein at least one reflector element is arranged behind the cut-out and said light source element.

The sheet may be made of a dielectric material, wherein preferably the sheet is made of polyethylene terephthalate (PET), polycarbonate (PC) or polyvinyl chloride (PVC).

Further, the sheet may have a thickness between 0.1 mm and 2 mm, preferably between 0.1 mm and 1 mm, in particular between 0.1 mm and 0.5 mm.

For example, the conductive layer forms an outer electrode, while the further conductive layer forms an inner electrode.

At last, the conductive layer may enclose a non-conductive area having a predetermined shape, wherein the shape of the further conductive layer is congruent with said predetermined shape.

Novel and inventive features of the present invention are set forth in the appended claims.

The present invention will be described in further detail with reference to the drawing, in which
- FIG 1: illustrates a schematic sectional side view of a control device according to a preferred embodiment of the present invention,
- FIG 2: illustrates a schematic front view of a sheet with conductive layers for the control device according to a first embodiment of the present invention,
- FIG 3: illustrates a schematic front view of the sheet with the conductive layers for the control device according to a second embodiment of the present invention,
- FIG 4: illustrates a schematic front view of the sheet with the conductive layers for the control device according to a third embodiment of the present invention, and
- FIG 5: illustrates a schematic front view of the sheet with the conductive layers for the control device according to a fourth embodiment of the present invention.

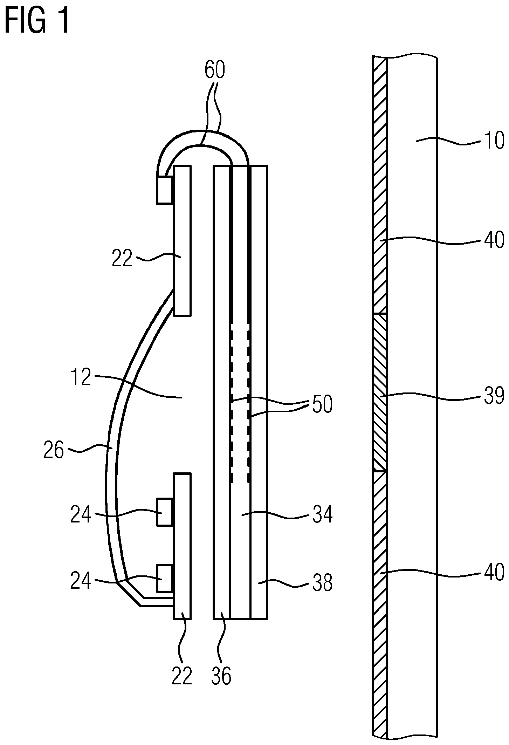

FIG 1 illustrates a schematic sectional side view of a control device for an appliance according to a preferred embodiment of the present invention. In this example, the control device is provided for a domestic appliance.

The control device comprises a front panel 10, a printed circuit board 22 and a transparent or opal sheet 34. In this example, the front panel 10, the printed circuit board 22 and the sheet 34 are arranged vertically. A front side of the control device is represented on the right hand side of FIG 1, while a rear side of said control device is represented on the left hand side of FIG 1. The printed circuit board 22 is arranged behind the front panel 10. The printed circuit board extends parallel to the front panel 10. The sheet 34 is arranged in front of the printed circuit board 22.

The printed circuit board 22 includes a cut-out 12. A printed icon 39 and a printed non-switchable area 40 are applied at a rear side of the front panel 10. The printed icon 39 is arranged in front of the cut-out 12 formed in the printed circuit board 22, while the printed non-switchable area 40 encloses said printed icon 39. The printed icon 39 and the printed non-switchable area 40 are arranged within one plane. In general, the control device may comprise one or more printed icons 39 at the rear side of the front panel 10 and one or more cut-outs 12 formed in the printed circuit board 22, wherein the printed icons 39 are arranged in front of corresponding cut-outs 22.

A conductive layer 50 is applied at the rear side and at the front side of the sheet 34 in each case. Said conductive layers 50 are arranged in front of the cut-out 12 of the printed circuit board 22. Said conductive layers 50 form two electrodes for a touch sensitive switch. In general, one or more conductive layers 50 are applied at the rear side and/or at the front side of the sheet 34. The conductive layers 50 are electrically connected to the rear side of the printed circuit board 22 via two lines 60. Preferably, the sheet 34 with the conductive layers 50 is aligned at the front side of the printed circuit board 22. In this example, the rear side of the sheet 34 is connected to the front side of the printed circuit board 22 by an adhesive tape 36. The sheet 34 is made of a dielectric material. For example, the sheet 34 is made of polyethylene terephthalate (PET), polycarbonate (PC), polyvinyl chloride (PVC) or the like. Preferably, the sheet 34 has a thickness between 0.1 mm and 1 mm.

Optionally, the printed circuit board 22 with the sheet 34 is pressed at the rear side of the front panel 10 by mechanical fastening elements. Alternatively or additionally, the front side of the sheet 34 is connected to the rear side of the front panel 10 by at least one further adhesive tape 38.

Further, the control element comprises a number of light source elements 24 and a reflector element 26. Preferably, the light source elements 24 are light emitting diodes (LED). The light source elements 24 are arranged at the rear side of the printed circuit board 22. Preferably, the light source elements 24 are arranged beside the cut-out 12 of the printed circuit board 22. The reflector element 26 is arranged at the rear side of the printed circuit board 22 and covers the light source elements 24 and the cut-out 12 of the printed circuit board 22. Light generated by the light source elements 24 is reflected by the reflector element 26 and passes the cut-out 12, the adhesive tape 36, the sheet 34, the further adhesive tape 38, the printed icon 39 and the front panel 10.

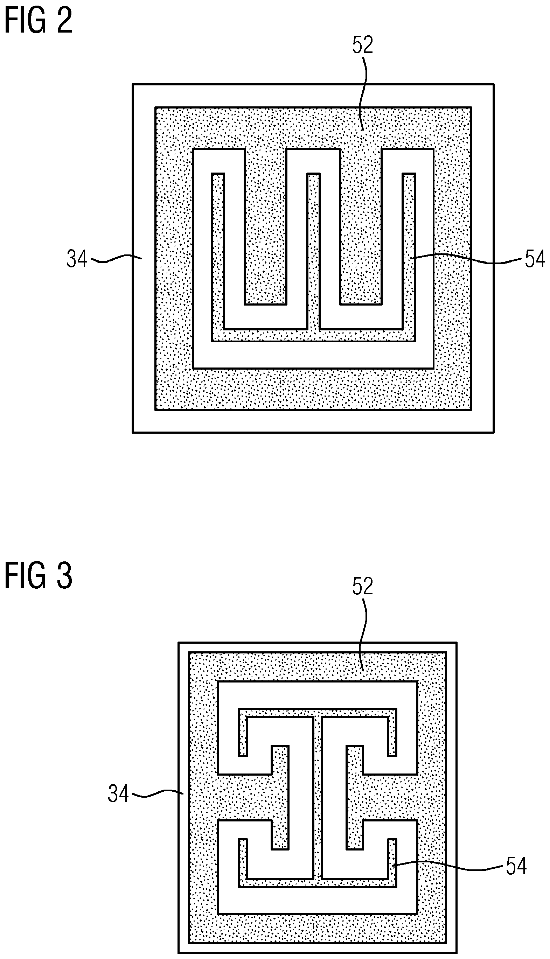

FIG 2 illustrates a schematic front view of the sheet 34 with conductive layers 52 and 54 for the control device according to a first embodiment of the present invention.

A first conductive layer 52 forms an outer electrode, while a second conductive layer 54 forms an inner electrode. The first conductive layer 52 and the second conductive layer 54 may be arranged at opposite sides of the sheet 34. Alternatively, the first conductive layer 52 and the second conductive layer 54 may be arranged at the same side of the sheet 34.

The first conductive layer 52 includes a rectangular path and two tongues. Said tongues extend into the inner area enclosed by said rectangular path. An E-shaped non-conductive area remains inside the first conductive layer 52. The second conductive layer 52 is arranged within said E-shaped non-conductive area.

The second conductive layer 52 is congruent with the E-shaped non-conductive area. The distance between the first conductive layer 52 and the second conductive layer 54 is minimised.

FIG 3 illustrates a schematic front view of the sheet 34 with the conductive layers 52 and 54 for the control device according to a second embodiment of the present invention. The first conductive layer 52 and the second conductive layer 54 may be arranged either at opposite sides of the sheet 34 or at the same side of the sheet 34.

The first conductive layer 52 includes a rectangular path and two tongues. Said tongues extend into the inner area enclosed by said rectangular path, wherein an H-shaped non-conductive area remains inside the first conductive layer 52. The second conductive layer 52 is arranged within the H-shaped non-conductive area and is congruent with said H-shaped non-conductive area. The distance between the first conductive layer 52 and the second conductive layer 54 is minimised.

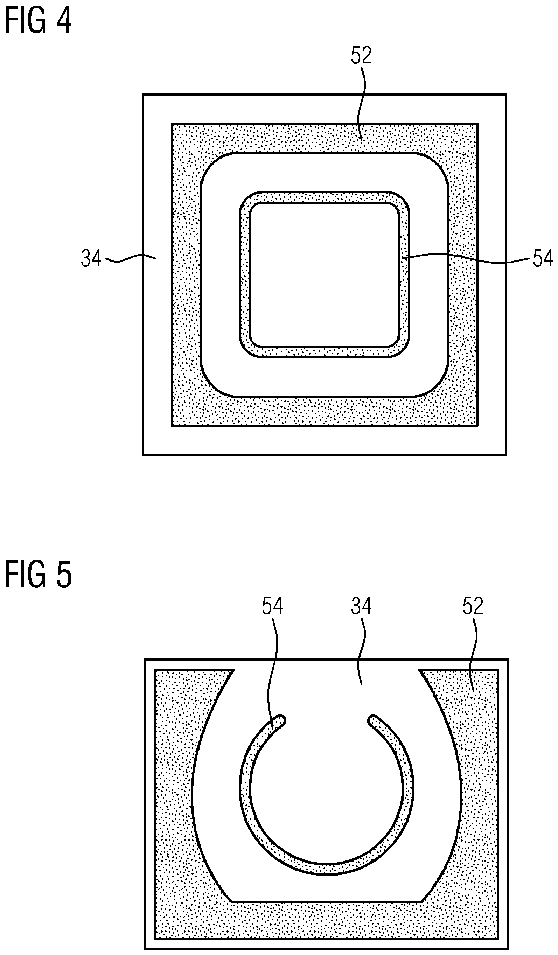

FIG 4 illustrates a schematic front view of the sheet 34 with the conductive layers 52 and 54 for the control device according to a third embodiment of the present invention. The first conductive layer 52 and the second conductive layer 54 may be arranged either at opposite sides of the sheet 34 or at the same side of the sheet 34.

The first conductive layer 52 is formed as a rectangular path. The second conductive layer 52 is also formed as a rectangular path and enclosed by the first conductive layer 52.

FIG 5 illustrates a schematic front view of the sheet 34 with the conductive layers 52 and 54 for the control device according to a fourth embodiment of the present invention. The first conductive layer 52 and the second conductive layer 54 may be arranged either at opposite sides of the sheet 34 or at the same side of the sheet 34.

The first conductive layer 52 is formed as a U-shaped or horseshoe-shaped path. The second conductive layer 52 is also formed as a horseshoe-shaped path and enclosed by the first conductive layer 52.

Although an illustrative embodiment of the present invention has been described herein with reference to the accompanying drawings, it is to be understood that the present invention is not limited to that precise embodiment, and that various other changes and modifications may be affected therein by one skilled in the art without departing from the scope of the invention as defined by the appended claims.

### List of reference numerals

- 10: front panel
- 12: cut-out
- 22: printed circuit board
- 24: light source element
- 26: reflector element
- 34: transparent or opal sheet
- 36: adhesive layer
- 38: further adhesive layer
- 39: printed icon
- 40: printed non-switchable area
- 50: conductive layer
- 52: first conductive layer
- 54: second conductive layer
- 60: line

## Claims

1. A control device, in particular for a domestic appliance, wherein:
- the control device comprises at least one front panel (10),
- the control device comprises at least one printed circuit board (22) arranged behind and parallel to the front panel (10),
- the printed circuit board (22) includes at least one cut-out (12),
- the control device comprises at least one transparent or opal sheet (34) arranged in front of the printed circuit board (22),
- a conductive layer (50; 54) is applied at the rear side of the sheet (34) and arranged in front of the cut-out (12) of the printed circuit board (22), and
- said conductive layer (50; 54) forms an electrode for a touch sensitive switch,
**characterised in that**
a further conductive layer (50; 52) is applied at the front side of the transparent or opal sheet (34) and arranged in front of the cut-out (12), wherein said further conductive layer (50; 52) forms a further electrode of the touch sensitive switch, and wherein the conductive layers (50; 52, 54) are applied at the sheet (34) according to predefined patterns, and wherein the conductive layers (50; 52, 54) at the rear side and front side of the sheet (34) have different patterns.

2. The control device according to claim 1,
**characterised in that**
the sheet (34) is a transparent or opal foil (34).

3. The control device according to any one of the preceding claims,
**characterised in that**
at least one electronic and/or electric circuit is arranged at the rear side of the printed circuit board (22).

4. The control device according to any one of the preceding claims,
**characterised in that**
the conductive layer (50; 52, 54) is or the conductive layers (50; 52, 54) are, respectively, electrically connected to the electronic and/or electric circuit at the printed circuit board (22).

5. The control device according to any one of the preceding claims,
**characterised in that**
the sheet (34) is aligned at the front side of the printed circuit board (22).

6. The control device according to any one of the preceding claims,
**characterised in that**
the rear side of the sheet (34) is connected to the front side of the printed circuit board (22) by at least one adhesive tape (36).

7. The control device according to any one of the preceding claims,
**characterised in that**
the printed circuit board (22) with the sheet (34) is pressed at the rear side of the front panel (10) by mechanical fastening elements.

8. The control device according to any one of the claims 1 to 6,
**characterised in that**
the front side of the sheet (34) is connected to the rear side of the front panel (10) by at least one further adhesive tape (38).

9. The control device according to any one of the preceding claims,
**characterised in that**
at least one light source element (24) is arranged at the rear side of the printed circuit board (22), wherein at least one reflector element (26) is arranged behind the cut-out (12) and said light source element (24).

10. The control device according to any one of the preceding claims,
**characterised in that**
the sheet (34) is made of a dielectric material.

11. The control device according to claim 10,
**characterised in that**
the sheet (34) is made of polyethylene terephthalate (PET), polycarbonate (PC) or polyvinyl chloride (PVC).

12. The control device according to any one of the preceding claims,
**characterised in that**
the sheet (34) has a thickness between 0.1 mm and 2 mm, preferably between 0.1 mm and 1 mm, in particular between 0.1 mm and 0.5 mm.

13. The control device according to any one of the preceding claims,
**characterised in that**
the further conductive layer (52) forms an outer electrode, while the conductive layer (54) forms an inner electrode.

14. The control device according to claim 13, **characterised in that**
the further conductive layer (52) encloses a non-conductive area having a predetermined shape, wherein the shape of the conductive layer (54) is congruent with said predetermined shape.

## Patentansprüche

1. Steuerungsvorrichtung, insbesondere für ein Haushaltsgerät, wobei:
- die Steuerungsvorrichtung mindestens eine Frontplatte (10) aufweist,
- die Steuerungsvorrichtung mindestens eine gedruckte Leiterplatte (22) aufweist, die hinter der Frontplatte (10) und parallel dazu angeordnet ist,
- die gedruckte Leiterplatte (22) mindestens einen Ausschnitt (12) umfasst,
- die Steuerungsvorrichtung mindestens eine transparente oder matte Platte (34) aufweist, die vor der gedruckten Leiterplatte (22) angeordnet ist,
- eine leitende Schicht (50; 54), die an der Rückseite der Platte (34) aufgebracht und vor dem Ausschnitt (12) der gedruckten Leiterplatte (22) angeordnet ist, und
- die leitende Schicht (50; 54) eine Elektrode für einen berührungsempfindlichen Schalter bildet,
**dadurch gekennzeichnet, dass**
eine weitere leitende Schicht (50; 52) an der Vorderseite der transparenten oder matten Platte (34) aufgebracht und vor dem Ausschnitt (12) angeordnet ist, wobei die weitere leitende Schicht (50; 52) eine weitere Elektrode des berührungsempfindlichen Schalters bildet, und wobei die leitenden Schichten (50; 52, 54) gemäß vordefinierten Mustern an der Platte (34) aufgebracht sind, und wobei die leitenden Schichten (50; 52, 54) an der Rückseite und der Vorderseite (34) unterschiedliche Muster aufweisen.

2. Steuerungsvorrichtung nach Anspruch 1,
**dadurch gekennzeichnet, dass**
die Platte (34) eine transparente oder matte Metallfolie (34) ist.

3. Steuerungsvorrichtung nach einem der vorhergehenden Ansprüche,
**dadurch gekennzeichnet, dass**
mindestens eine elektronische und/oder elektrische Schaltung an der Rückseite der gedruckten Leiterplatte (22) angeordnet ist.

4. Steuerungsvorrichtung nach einem der vorhergehenden Ansprüche,
**dadurch gekennzeichnet, dass**
dass die leitende Schicht (50; 52, 54) oder die leitenden Schichten (50; 52, 54) mit der elektronischen und/oder elektrischen Schaltung an der gedruckten Leiterplatte (22) elektrisch verbunden ist bzw. sind.

5. Steuerungsvorrichtung nach einem der vorhergehenden Ansprüche,
**dadurch gekennzeichnet, dass**
die Platte (34) an der Vorderseite der gedruckten Leiterplatte (22) ausgerichtet ist.

6. Steuerungsvorrichtung nach einem der vorhergehenden Ansprüche,
**dadurch gekennzeichnet, dass**
die Rückseite der Platte (34) durch mindestens ein Klebeband (36) mit der Vorderseite der gedruckten Leiterplatte (22) verbunden ist.

7. Steuerungsvorrichtung nach einem der vorhergehenden Ansprüche,
**dadurch gekennzeichnet, dass**
die gedruckte Leiterplatte (22) mit der Platte (34) durch mechanische Befestigungsmittel an die Rückseite der Frontplatte (10) gepresst ist.

8. Steuerungsvorrichtung nach einem der Ansprüche 1 bis 6,
**dadurch gekennzeichnet, dass**
die Vorderseite der Platte (34) durch mindestens ein weiteres Klebeband (38) mit der Rückseite der Frontplatte (10) verbunden ist.

9. Steuerungsvorrichtung nach einem der vorhergehenden Ansprüche,
**dadurch gekennzeichnet, dass**
mindestens ein Lichtquellenelement (24) an der Rückseite der gedruckten Leiterplatte (22) angeordnet ist, wobei mindestens ein Reflektorelement (26) hinter dem Ausschnitt (12) und dem Lichtquellenelement (24) angeordnet ist.

10. Steuerungsvorrichtung nach einem der vorhergehenden Ansprüche,
**dadurch gekennzeichnet, dass**
die Platte (34) aus einem dielektrischen Material hergestellt ist.

11. Steuerungsvorrichtung nach Anspruch 10,
**dadurch gekennzeichnet, dass**
die Platte (34) aus Polyethylenterephthalat (PET), Polycarbonat (PC) oder Polyvinylchlorid (PVC) hergestellt ist.

12. Steuerungsvorrichtung nach einem der vorhergehenden Ansprüche,
**dadurch gekennzeichnet, dass**
die Platte (34) eine Dicke von 0,1 mm bis 2 mm, vorzugsweise 0,1 mm bis 1 mm und insbesondere 0,1 mm bis 0,5 mm aufweist.

13. Steuerungsvorrichtung nach einem der vorhergehenden Ansprüche,
**dadurch gekennzeichnet, dass**
die weitere leitende Schicht (52) eine äußere Elektrode bildet, während die leitende Schicht (54) eine innere Elektrode bildet.

14. Steuerungsvorrichtung nach Anspruch 13,
**dadurch gekennzeichnet, dass**
die weitere leitende Schicht (52) einen nicht leitenden Bereich mit einer vorbestimmten Form einschließt, wobei die Form der leitenden Schicht (54) der vorbestimmten Form entspricht.

## Revendications

1. Dispositif de commande, en particulier pour un appareil ménager, dans lequel :
- le dispositif de commande comprend au moins un panneau avant (10),
- le dispositif de commande comprend au moins une carte de circuit imprimé (22) disposée derrière et parallèle au panneau avant (10),
- la carte de circuit imprimé (22) comporte au moins une découpe (12),
- le dispositif de commande comprend au moins une feuille transparente ou opale (34) disposée devant la carte de circuit imprimé (22),
- une couche conductrice (50 ; 54) est appliquée sur le côté arrière de la feuille (34) et disposée devant la découpe (12) de la carte de circuit imprimé (22), et
- ladite couche conductrice (50 ; 54) forme une électrode pour un commutateur tactile,
**caractérisé en ce que**
une autre couche conductrice (50 ; 52) est appliquée sur le côté avant de la feuille transparente ou opale (34) et disposée devant la découpe (12), ladite autre couche conductrice (50 ; 52) formant une autre électrode du commutateur tactile, et les couches conductrices (50 ; 52, 54) étant appliquées au niveau de la feuille (34) selon des motifs prédéfinis, et les couches conductrices (50 ; 52, 54) sur le côté arrière et le côté avant de la feuille (34) ayant des motifs différents.

2. Dispositif de commande selon la revendication 1, **caractérisé en ce que**
la feuille (34) est un film transparent ou opale (34) .

3. Dispositif de commande selon l'une quelconque des revendications précédentes,
**caractérisé en ce que**
au moins un circuit électronique et/ou électrique est disposé sur le côté arrière de la carte de circuit imprimé (22).

4. Dispositif de commande selon l'une quelconque des revendications précédentes,
**caractérisé en ce que**
la couche conductrice (50 ; 52, 54) est ou les couches conductrices (50 ; 52, 54) sont, respectivement, reliée(s) électriquement au circuit électronique et/ou électrique au niveau de la carte de circuit imprimé (22) .

5. Dispositif de commande selon l'une quelconque des revendications précédentes,
**caractérisé en ce que**
la feuille (34) est alignée sur le côté avant de la carte de circuit imprimé (22).

6. Dispositif de commande selon l'une quelconque des revendications précédentes,
**caractérisé en ce que**
le côté arrière de la feuille (34) est relié au côté avant de la carte de circuit imprimé (22) par au moins un ruban adhésif (36).

7. Dispositif de commande selon l'une quelconque des revendications précédentes,
**caractérisé en ce que**
la carte de circuit imprimé (22) avec la feuille (34) est comprimée sur le côté arrière du panneau avant (10) par des éléments de fixation mécanique.

8. Dispositif de commande selon l'une quelconque des revendications 1 à 6,
**caractérisé en ce que**
le côté avant de la feuille (34) est relié au côté arrière du panneau avant (10) par au moins un autre ruban adhésif (38).

9. Dispositif de commande selon l'une quelconque des revendications précédentes,
**caractérisé en ce que**
au moins un élément source de lumière (24) est disposé sur le côté arrière de la carte de circuit imprimé (22), au moins un élément réflecteur (26) étant disposé derrière la découpe (12) et ledit élément source de lumière (24).

10. Dispositif de commande selon l'une quelconque des revendications précédentes,
**caractérisé en ce que**
la feuille (34) est constituée d'un matériau diélectrique.

11. Dispositif de commande selon la revendication 10, **caractérisé en ce que**
la feuille (34) est constituée de téréphtalate de polyéthylène (PET), polycarbonate (PC) ou polychlorure de vinyle (PVC).

12. Dispositif de commande selon l'une quelconque des revendications précédentes,
**caractérisé en ce que**
la feuille (34) a une épaisseur comprise entre 0,1 mm et 2 mm, de préférence entre 0,1 mm et 1 mm, en particulier entre 0,1 mm et 0,5 mm.

13. Dispositif de commande selon l'une quelconque des revendications précédentes,
**caractérisé en ce que**
l'autre couche conductrice (52) forme une électrode externe, tandis que la couche conductrice (54) forme une électrode interne.

14. Dispositif de commande selon la revendication 13, **caractérisé en ce que**
l'autre couche conductrice (52) délimite une zone non conductrice ayant une forme prédéterminée, la forme de la couche conductrice (54) étant congruente avec ladite forme prédéterminée.
